# EUROPEAN PATENT APPLICATION

(11) **EP 1 463 154 A2**
(43) Date of publication of application: **29.09.2004**
(21) Application number: 04251497.6
(22) Date of filing: 16.03.2004
(51) Int. Cl.: H01R 12/18

(54) **Electrical connector**

(30) Priority: 20.03.2003 JP 2003078301
(71) Applicant: Tyco Electronics AMP K.K., Kawasaki, Kanagawa 213-8535 (JP); FUJITSU LIMITED, Kawasaki-shi, Kanagawa 211-8588 (JP)
(72) Inventor: Takeshi, Kimura, c/o Tyco Electronics AMT K.K., Kawasaki-shi, Kanagawa 213-8535 (JP); Kunihiko, Shimizu, co Fujitsu Limited, Kawasaki-shi, Kanagawa 211-8588 (JP); Kazuya, Orui, c/o Fujitsu Limited, Kawasaki-shi, Kanagawa 211-8588 (JP); Hiroyuki, Otaguro, c/o Fujitsu Limited, Kawasaki-shi, Kanagawa 211-8588 (JP); Rie, Takada, c/o Fujitsu Limited, Kawasaki-shi, Kanagawa 211-8588 (JP)
(74) Representative: Johnstone, Douglas Ian

(57) **Abstract**

Electrical connector including a housing accommodating an array of sub-boards (120) each of which has pattern of lands (123) on an insulator. The lands (123) include conductors with contact sections (121) for connection to a mating connector and conductor parts (123a, 123b) which terminate close to a terminal-side edge of the insulator. Terminals in the housing having press-fit parts for insertion into through-holes in a main board and include fork shaped contacts for engaging the conductor parts (123a, 123b) close to the terminal-side edge. The land pattern prevents the sub-boards (120) from being buckled, by forcible engagement of the terminal therewith when the press-fit parts of the terminals are pressed into the through holes in the main board. Ends of the conductor parts (123a, 123b) adjacent the terminal-side edge (124) and narrower that immediately adjacent parts thereof.

## Description

The present invention relates to an electrical connector in which multiple substrates (referred to as sub-boards herein) are secured in an array.

Conventionally, electrical connectors in which multiple sub-boards known as chicklets are secured in an array are used as electrical connectors which electrically connect multiple circuit boards--for example, a circuit board called a motherboard and a circuit board known as a daughter board--with each other. For example, U.S. Patent No. 6,171,115 discloses an electrical connector, having multiple terminals equipped with press-fit parts to be inserted into through-holes in a main board which corresponds to the daughter board described above; land patterns connected to the terminals; multiple sub-boards (chicklets) equipped with a contact section to be connected to a mating connector installed on a circuit board which corresponds to the motherboard described above; and a housing used to secure the boards in an array.

Products based on the technique disclosed in U.S. 6,171,115 have been put on the market.

However, with the electrical connector according to the conventional technique, the terminals bite into the lower end of the sub-boards (chicklets), buckling the lower end of the sub-boards when the press-fit parts of the terminals are press-fitted into the through-holes in the main board. Substantial buckling will displace the press-fit parts of the terminals, weakening the fit in the through-holes in the main board and thereby lowering the press-fitting force of the press-fit parts. Thus, the conventional technique has the problem that the electrical connector may not be mounted properly on the main board: for example, the press-fit parts of the terminals may not be inserted to a prescribed depth in the through-holes in the main board, lowering the reliability of connection and causing bad connections.

In view of the above circumstances, the present invention has an object to provide an electrical connector which can be mounted more reliably on a main board.

To achieve the above object, the present invention provides an electrical connector, having: multiple terminals equipped with press-fit parts to be inserted into through-holes in a main board; multiple sub-boards equipped with land patterns connected to the terminals and a contact section to be connected to a mating connector, where the land patterns consist of a conductor formed on an insulator; and a housing used to secure the multiple sub-boards in an array, wherein owing to a conductor which extends close to the terminal-side edge of the insulator, the land patterns prevent the sub-boards from being buckled by being bitten or forcibly engaged by the terminals when the press-fit parts are inserted into the through-holes in the main board.

The electrical connector according to the present invention reinforces the insulator of the sub-boards with the conductor which forms the land patterns by extending the conductor close to the terminal-side edge of the insulator which constitutes the sub-boards. This prevents the sub-boards from being buckled by being bitten by the terminals when the connector is press-fitted. This also reduces displacement of the terminals, and thereby prevents the press-fitting force of the press-fit parts from being lowered. Consequently, the electrical connector can be mounted more reliably on the main board.

Alternatively, with a conductor extending close to the terminal-side edge of the insulator, the land patterns may serve as stopping means which stop displacement of the terminals when the press-fit parts are inserted into the through-holes in the main board. Also, owing to a conductor which extends close to the terminal-side edge of the insulator, the land patterns may serve as prevention means which prevents progress of buckling of the sub-boards bitten by the terminals when the press-fit parts are inserted into the through-holes in the main board.

These two aspects are not intended to prevent buckling of the sub-boards completely. They accept buckling of the sub-boards within the bounds of not lowering the press-fitting force of the press-fit parts or accept, to some extent, displacement of the terminals which begins as the terminals start to buckle. However, these aspects can still prevent the press-fitting force of the press-fit parts from being lowered and thus allows the electrical connector to be mounted more reliably on the main board.

Preferably, in the electrical connector according to the present invention, that part of the land patterns which is close to the edge is narrower than the other part of the land patterns.

Solely from the viewpoint of preventing buckling, preferably that part of the land patterns which is close to the edge is also wide. However, it is important to secure insulation distance between a land pattern and the terminals connected to the adjacent land patterns. By reducing the width of that part of the land patterns which is close to the edge, it is possible to prevent the terminals from biting into the sub-boards while securing the insulation distance and prevent the press-fitting force of the press-fit parts of the terminals from being lowered.

In the electrical connector according to the present invention, if an insulator harder than the insulator forming the sub-boards is placed between the terminals and the sub-boards, it is possible to prevent the terminals from biting into the sub-boards as well as to prevent the press-fitting force of the press-fit parts of the terminals from being lowered when the connector is press-fitted.

As described above, the electrical connector according to the present invention prevents the press-fitting force of the press-fit parts from being lowered and allows the electrical connector to be mounted much more reliably on the main board.

The invention will now be described by way of example only with reference to the accompanying drawings in which:
Fig. 1 is a perspective view showing a first connector according to a first embodiment of the present invention and a second connector which mates with the first connector;
Parts (A), (B), (C), (D), and (E) of Fig. 2 are a front view, plan view, left side view, right side view, and bottom view, respectively, of the first connector;
Fig. 3 is a sectional view showing the first connector and second connector in mated condition;
Fig. 4 is a diagram showing a first surface of a sub-board of the first connector;
Fig. 5 is a diagram showing a second surface of the sub-board;
Fig. 6 is a schematic diagram showing an enlarged view of terminals of the first connector;
Fig. 7 is a sectional view taken along line A-A' in Fig. 6;
Fig. 8 is a diagram showing a substrate in a connector according to a second embodiment of the present invention; and
Fig. 9 is a schematic diagram showing an enlarged view of terminals of the connector according to the second embodiment of the present invention.

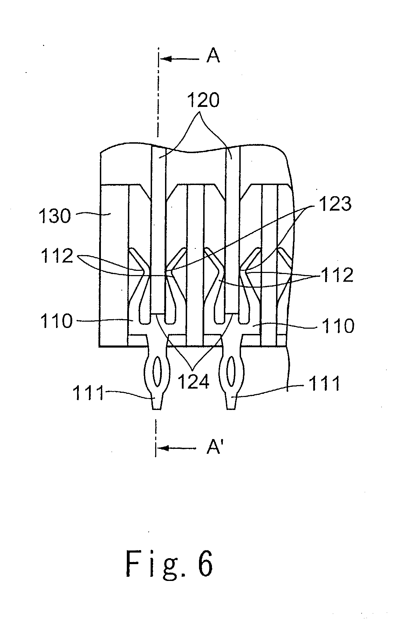

The first connector 100 includes terminals 110 (see, for example, Fig. 6) equipped with press-fit parts 111 to be press-fitted into through-holes in a daughter board (not shown) which corresponds to the main board according to the present invention, multiple sub-boards (chicklets) 120 arranged in an array, and a housing 130 which secures the multiple sub-boards 120 in an array.

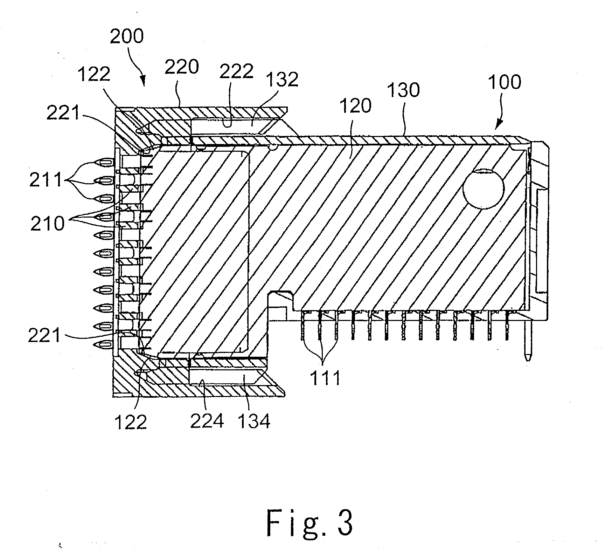

The second connector 200 is provided with press-fit parts 211 to be press-fitted into through-holes in a motherboard to be connected with the daughter board via the first and second connectors 100 and 200. It includes, multiple female terminals 210 (see, for example, Fig. 3) which engage contact sections 121 provided on the sub-boards 120 of the first connector 100 and a housing 220 which secures the multiple female terminals 210 and has an opening to accept the first connector 100.

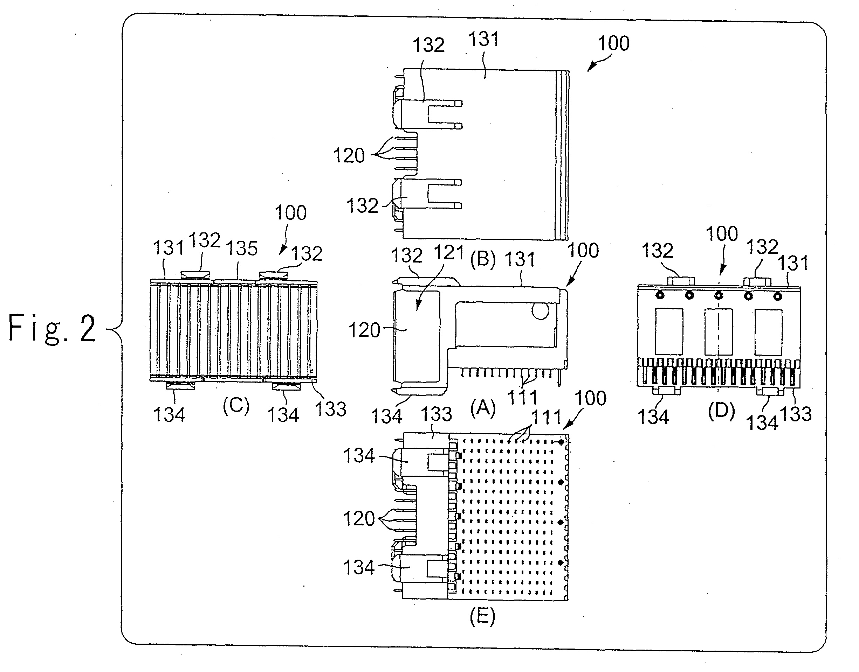

The terminals 110 of the first connector 100 are arranged two-dimensionally in large numbers as can be seen from their respective press-fit parts 111 shown in Part (E) of Fig. 2. Accordingly, a large number of through-holes are formed in the daughter board (not shown) to accept the press-fit parts 111.

The sub-boards 120 of the electrical connector 100 are arranged in the vertical direction in Part (E) of Fig. 2 and each of them is connected to a corresponding horizontal row of terminals from among the large number of terminals 110 arranged two-dimensionally in Part (E) of Fig. 2. Structure of connection between the sub-boards 120 and terminals 110 will be described later.

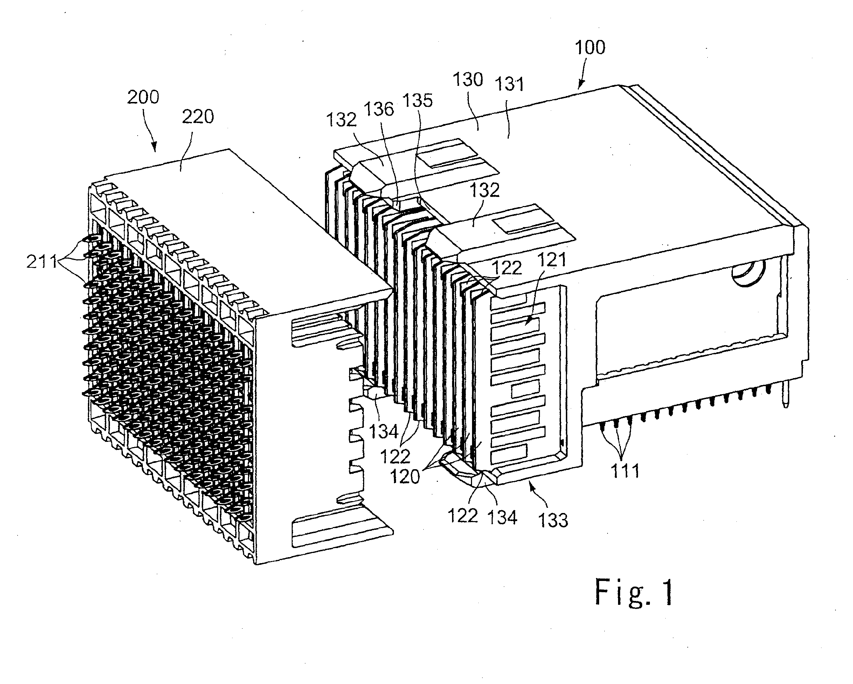

As shown in Fig. 1, the contact section 121 is formed on that end of each sub-board 120 which is mated with terminals on the second connector 200, i.e., the mating connector. On that side on which the contact section 121 is formed, corners of each sub-board 120 are chamfered 122. The chamfers 122 are used for vertical positioning of the sub-boards 120 in Fig. 1 when the first connector 100 and second connector 200 are mated.

Also, in the housing 130 of the first connector 100, first convex guides 132 are formed on an top wall 131 as viewed in the direction shown in Fig. 1 and second convex guides 134 are formed on a bottom wall 133 as viewed in the direction shown in Fig. 1.

The first convex guides 132 are installed at two locations on the top wall 131 at a certain distance from each other and the second convex guides 134 are installed at two locations on the bottom wall 133 separated by a distance different from the distance between the first convex guides 132 on the top wall 131. As shown in Fig. 3, in the housing 220 of the second connector 200 which is the mating connector, a pair of first concave guides 222 and a pair of second concave guides 224 are installed at locations which correspond, respectively, to the locations of the pair of first convex guides 132 and the pair of second convex guides 134 on the housing 130 of the first connector 100. The first convex guides 132 and second convex guides 134 together with the corresponding first concave guides 222 and second concave guides 224 constitute a rough guide mechanism which roughly guides the mating between the first connector 100 and second connector 200 at the initial stage of mating.

When the first connector 100 and second connector 200 are mated together, the second connector 200 has tapers 221 (see, Fig. 3) which correspond to the beveled edges 122 at locations which correspond to the beveled edges 122, i.e., the chamfers formed on top and bottom corners of the contact section 121 of the sub-boards 120. The beveled edges 122 and tapers 221 constitute a precision guide mechanism which guides the mating between the first connector 100 and second connector 200 more precisely than the rough guide mechanism in an advanced stage of mating.

A recess 135 is formed between the first convex guides 132 in the housing 130 of the first connector 100. The entrance corners of the recess 135 are chamfered 136. The second connector 200 has a protrusion (not shown) in the depth between the first concave guides 222 which correspond to the first convex guides 132 of the first connector 100. The protrusion is formed at a location which corresponds to the recess 135 and enters the recess 135 when the first connector 100 and second connector 200 are mated together. Corners of the protrusion are tapered corresponding to the chamfers 136 on the entrance corners of the recess 135. Details of the structure of the second connector 200 are not shown because the second connector 200 does not relate specifically to the subject of the present invention.

The recess 135 between the first convex guides 132 of the first connector 100 as well as the corresponding protrusion on the second connector 200 are constituent parts of the precision guide mechanism.

Thus, at the initial stage of mating, the first connector 100 and second connector 200 are mated together by being roughly guided as the first convex guides 132 and second convex guides 134 of the first connector 100 enter the first concave guides 222 and second concave guides 224 of the second connector 200. The distance between the two first convex guides 132 (and the corresponding two first concave guides 222) differs from the distance between the two second convex guides 134 (and the corresponding two second concave guides 224) to prevent the connectors from being mated upside down by mistake.

In an advanced stage of mating, a precision guide in the vertical direction of Figs. 1 and 3 is provided by the beveled edges 122 formed on the contact-section-side (121) corners of the sub-boards 120 of the first connector 100 in conjunction with the corresponding tapers 221 on the housing 220 of the second connector 200 while a horizontal precision guide is provided by the recess 135 formed between the two first convex guides 132 on the housing 130 of the first connector 100 and the corresponding protrusion (not shown) formed in the housing 220 of the second connector 200. Thus, at the initial stage, mating is started even if the first connector 100 and second connector 200 are positioned more or less imprecisely, and at the advanced stage, precision mating is achieved with the help of the precision guide mechanism.

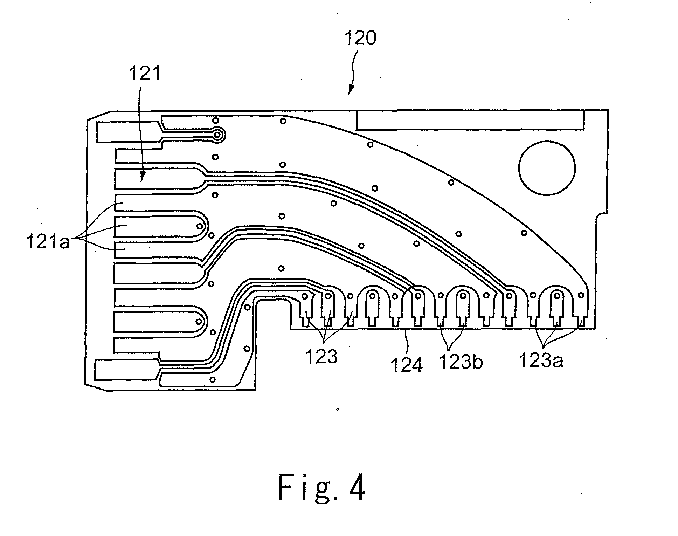

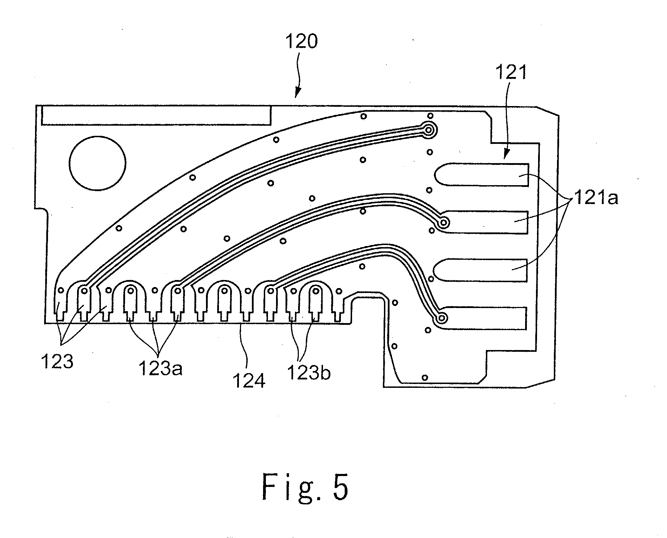

Fig. 4 is a diagram showing a first surface of a sub-board of the first connector and Fig. 5 is a diagram showing a second surface of the sub-board.

The sub-board 120 contains the contact section 121 which is to be inserted in the second connector and which faces sideways as well as multiple land patterns 123 arranged along an edge 124 of the sub-board and pointing downward. The land patterns 123 consist of conductor patterns formed on a plate of an insulator which is the base material of the sub-board 120. Each land pattern 123 is connected to a respective contact pattern 121a arranged on the contact section 121.

Each land pattern 123 extends close to the edge 124 of the sub-board. As shown in Figs. 4 and 5, only a small area consisting solely of an insulator remains between the edge 124 and a bottom edge 123b of the land pattern 123. The reason why the area consisting solely of an insulator is left on the edge 124 of the sub-board 120 is to eliminate the possibility of peeling off the land patterns 123 even slightly when producing the sub-board 120 by cutting a large wafer. Desirably, the distance between the edge 124 of the sub-board 120 and the bottom edge 123b of the land pattern 123 is 0.3 mm or less.

Part of each land pattern which is close to the edge 124 of the sub-board 120 is narrower than the other part of the land pattern 123. The land patterns 123 are connected with the respective terminals 110 (see Figs. 1 to 3) of the first connector 100 as described later. The reason why that part of each land pattern which is close to the edge 124 of the sub-board 120 is narrower than the other part of the land pattern 123 is to secure insulation distance between the land pattern 123 and the terminals 110 connected to the adjacent land patterns 123. This will be further described later.

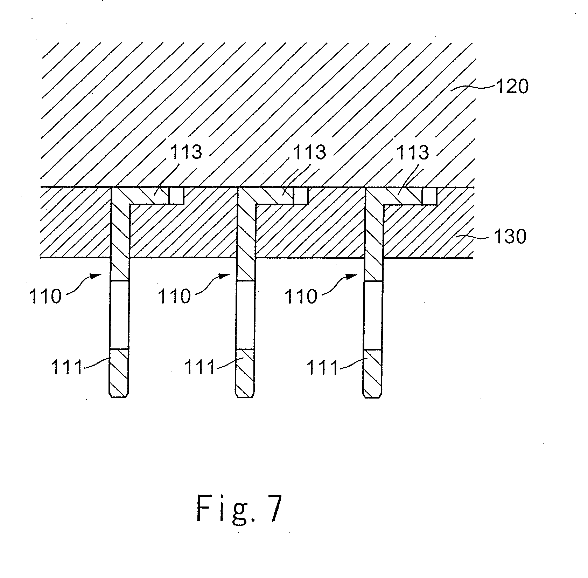

Fig. 6 is a schematic diagram showing an enlarged view of terminals of the first connector and Fig. 7 is a sectional view taken along line A-A' in Fig. 6.

The figure shows terminals 110 each of which has a press-fit part 111 to be inserted into a through-hole in the main board (not shown). A fork-shaped contact 112 is formed on that part of the terminal 110 which is located inside the first connector housing 130 to pinch the land pattern 123 (see Figs. 4 and 5) of the sub-board 120. Also, a sub-board support 113 (see Fig. 7) is formed on that part of the terminal 110 which contacts the edge 124 of the sub-board 120. It is bent into the paper in Fig. 6 and extends along the edge 124 of the sub-board 120.

The terminals 110 of this shape are arranged two-dimensionally in the housing as shown in Part (E) of Fig. 2. When the first connector 100 is assembled, the land patterns 123 of the sub-boards 120 are inserted into the contacts 112 of the terminals 110 secured in the housing 130.

The sub-board supports 113 of the terminals 110 support the lower end of the sub-boards 120 when the press-fit parts 111 are press-fitted into the through-holes in the main board. They serve to distribute the pressure placed by the terminals 110 on the sub-boards 120, reducing buckling of the bottom edges 124 of the sub-boards 120, when the terminals are press-fitted. However, the pressure distribution effect of the sub-board supports 113 alone cannot completely prevent the bottom edges 124 of the sub-boards 120 from being buckled. Thus, as described with reference to Figs. 4 and 5, the land patterns 123 formed on the sub-boards 120 extend to a location close to the bottom edges 124 of the sub-boards 120. The land patterns 123 reinforce the part around the bottom edges 124 of the sub-boards 120, and thereby prevent the bottom edges 124 of the sub-boards 120 from being buckled. Consequently, the first connector 100 can be press-fitted into the through-holes in the main board (daughter board) with high reliability.

Each sub-board support 113 of the terminal 110 extends to near the adjacent land pattern 123 along the bottom edge 124 of the sub-board 120 as shown in Fig. 7. If the tip of the sub-board support 113 is too close to the lower end of the adjacent land pattern 123, it may become difficult to secure insulation distance, resulting in a lowered withstand voltage. To avoid this situation, that part of the land pattern 123 which is close to the bottom edge 124 of the sub-board 120 is narrowed to keep clear of the sub-board support 113 of the terminal 110.

Next, a second embodiment of the present invention will be described. Regarding the second embodiment, description will be given of only those parts which are different from the first embodiment described above.

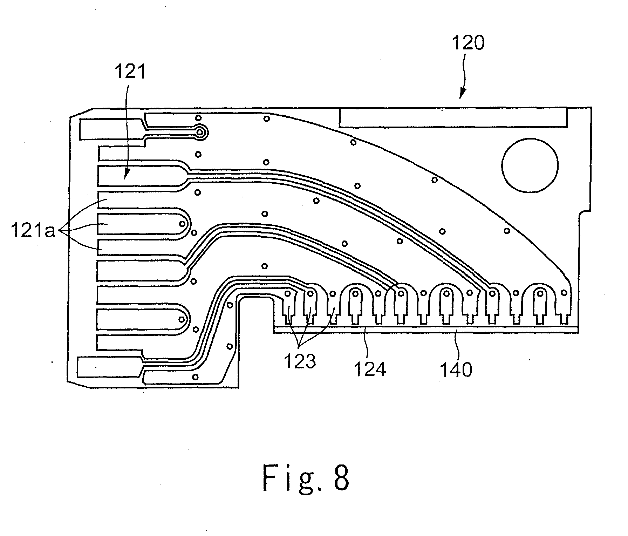

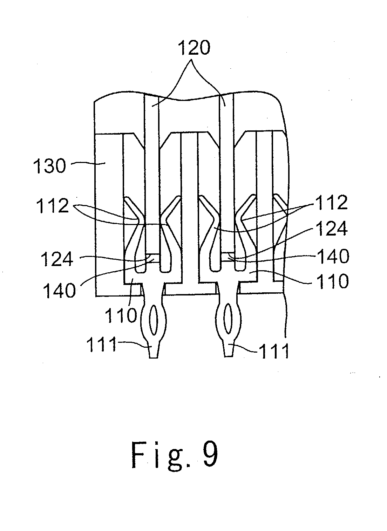

Fig. 8 is a diagram showing a substrate in a connector according to a second embodiment of the present invention and Fig. 9 is a schematic diagram showing an enlarged view of terminals of the connector according to the second embodiment of the present invention. Figs. 8 and 9 correspond, respectively, to Figs. 4 and 6 presented above in relation to the first embodiment. The same components as those in Figs. 4 and 6 will be denoted by the same reference numerals as the corresponding components in Figs. 4 and 6, and description thereof will be omitted.

According to the second embodiment, a thin insulating plate 140 is installed along the bottom edge 124 of the sub-board 120 as shown in Fig. 8 and the terminals 110 are connected to the sub-boards 120 with the insulating plate 140 sandwiched between the sub-boards 120 and terminals 110 as shown in Fig. 9. An insulator, which is harder than the insulator used as the base material of the sub-boards 120, is used for the insulating plate 140. By sandwiching the insulating plates 140 between the bottom edge 124 of the sub-boards 120 and the sub-board supports 113 of the terminals 110 (see Fig. 7), it is possible to more reliably prevent the bottom edges 124 of the sub-boards 120 from being buckled when the press-fit parts 111 of the terminals 110 are press-fitted into the through-holes in the main board.

## Claims

1. An electrical connector (100), comprising:
a plurality of terminals (110) equipped with press-fit parts (111) to be inserted into through-holes in a main board;
a plurality of sub-boards (120) equipped with land patterns (123) connected to the terminals (110) and a contact section (121) to be connected to a mating connector (200), where the land patterns (123) consist of a conductor formed on an insulator; and
a housing (130) used to secure the plurality of sub-boards (120) in an array,
wherein owing to a conductor (123a, 123b) which extends close to a terminal-side edge (124) of the insulator, the land patterns (123) prevent the sub-boards (120) from being buckled by being bitten by the terminals (110) when the press-fit parts (111) are inserted into the through-holes in the main board.

2. An electrical connector, comprising:
a plurality of terminals (110) equipped with press-fit parts (111) to be inserted into through-holes in a main board;
a plurality of sub-boards (120) equipped with land patterns (123) connected to the terminals (110) and a contact section (121) to be connected to a mating connector (200), where the land patterns (123) consist of a conductor formed on an insulator; and
a housing (130) used to secure the plurality of sub-boards (120) in an array,
wherein with a conductor (123a, 123b) extending close to a terminal-side edge (124) of the insulator, the land patterns (123) serve as stopping means which stop displacement of the terminals (110) when the press-fit parts (111) are inserted into the through-holes in the main board.

3. An electrical connector, comprising:
a plurality of terminals (110) equipped with press-fit parts (111) to be inserted into through-holes in a main board;
a plurality of sub-boards (120) equipped with land patterns (123) connected to the terminals (110) and a contact section (121) to be connected to a mating connector (200), where the land patterns (123) consist of a conductor formed on an insulator; and
a housing (130) used to secure the plurality of sub-boards (120) in an array,
wherein owing to a conductor (123a, 123b) which extends close to a terminal-side edge (124) of the insulator, the land patterns (123) serve as prevention means which prevents progress of buckling of the sub-boards (120) bitten by the terminals (110) when the press-fit parts (111) are inserted into the through-holes in the main board.

4. The electrical connector, according to claim 1, 2 or 3 wherein a part (123a, 123b) of one of the land patterns (123) which is close to the edge (124) is narrower than another part of the land pattern (123).

5. The electrical connector, according to claim 4, wherein the part (123a, 123b) of the land pattern (123) which is close to the edge (124) is narrower than another immediately adjacent part of the land pattern (123).

6. The electrical connector, according to any preceding claim, wherein an insulator (140) harder than the insulator forming the sub-boards (120) is placed between the terminals (110) and the sub-boards (120).
